(19) Europäisches Patentamt
European Patent Office
Office européen des brevets

(11) Publication number: 0 136 679
B1

(12) EUROPEAN PATENT SPECIFICATION

(45) Date of publication of patent specification: 16.12.87

(51) Int. Cl.$^4$: C 08 G 59/68, G 03 C 1/68

(21) Application number: 84111648.6

(22) Date of filing: 28.09.84

# (54) Photopolymerizable epoxy resin composition.

(30) Priority: 30.09.83 JP 180400/83
30.09.83 JP 180401/83

(43) Date of publication of application:
10.04.85 Bulletin 85/15

(45) Publication of the grant of the patent:
16.12.87 Bulletin 87/51

(84) Designated Contracting States:
CH DE FR GB LI

(56) References cited:
EP-A-0 011 918
GB-A-2 034 317

(73) Proprietor: Kabushiki Kaisha Toshiba
72, Horikawa-cho Saiwai-ku
Kawasaki-shi Kanagawa-ken 210 (JP)

(72) Inventor: Hayase, Shuzi c/o Kabushiki Kaisha Toshiba
72, Horikawa-cho Saiwai-ku
Kawasaki-shi Kanagawa-ken (JP)
Inventor: Onishi, Yasunobu c/o Kabushiki Kaisha Toshiba
72, Horikawa-cho Saiwai-ku
Kawasaki-shi Kanagawa-ken (JP)
Inventor: Suzuki, Shuichi c/o Kabushiki Kaisha Toshiba
72, Horikawa-cho Saiwai-ku
Kawasaki-shi Kanagawa-ken (JP)
Inventor: Wada, Moriyasu c/o Kabushiki Kaisha Toshiba
72, Horikawa-cho Saiwai-ku
Kawasaki-shi Kanagawa-ken (JP)

(74) Representative: Hansen, Bernd, Dr.rer.nat. et al
Hoffmann, Eitle & Partner Patentanwälte
Arabellastrasse 4
D-8000 München 81 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 136 679 B1

## Description

This invention relates to a photopolymerizable epoxy resin composition having a novel composition, more particularly to an epoxy resin composition having good photocurability, less corrosive properties and excellent electrical characteristics.

In the specifications of US 3,205,156 and 3,708,296, there are disclosed light-susceptible epoxy resin compositions containing an aryldiazonium salt and an aryldiazonium salt of a halogen-containing complex anion, respectively. These compositions are restricted in their availabilities for reasons of (1) a less thermal stability, (2) spectral responses being limited to an ultraviolet region of spectrum, and (3) the occurrence of pinholes and air bubbles in a cured composition due to the generation of nitrogen during photopolymerization.

Also when oxetane or a mixture of oxetane and an epoxy resin is photopolymerized by the use of aforesaid aryldiazonium salt, the same problem as mentioned above will arise (see the specification of US 3,835,003).

Some patents (see specification of US 3,711,390, 3,711,931, 3,816,278, 3,817,850 and 3,817,845) disclose methods for stabilizing mixtures of diazonium salts and epoxides. These methods, however, are unsatisfactory for several reasons. For example, with regard to their stability, its good state can merely be retained for so short a period as to be represented by the unit of days, and the addition of a stabilizer, which is a non-reactive material, will contaminate a desired composition, with the consequence that this added material will soften a product thereof and will deteriorate a photo-setting speed.

Further, in the specification of US 3,450,613, there is disclosed a photopolymerizable epoxy resin composition comprising a reaction product of an epoxy resin prepolymer and an ethylenically unsaturated organic acid, a light-susceptible agent and optionally a poly-functional acid or hydrochloric acid.

The gelation of this composition can be accomplished by the photopolymerization of an ethylenically unsaturated portion in the reaction product when exposed to ultraviolet rays, but for the sake of the complete cure of the composition, it is necessary that an epoxy resin portion of the composition is caused to carry out a curing reaction. For this purpose, it is finally required to give a thermal treatment to the composition. In other words, in order to accomplish the complete polymerization (curing) of this composition, both light and heat are needful. For this reason, applicable fields of the composition are inevitably limited. In addition thereto, this composition has the problems of being sensitive to enzymes and being low in thermal stability.

On the other hand, as photo-setting catalysts for the photopolymerizable epoxy resin composition, complexes represented by the following formula are known:

$$\begin{matrix} Y^{\ominus} \\ Ar—X^{\oplus}—Ar \end{matrix}$$

wherein Ar is a phenyl group or the like; X is an iodine atom, sulfur atom, diazo group or the like; and Y is $BF_4$, $PF_6$, $AsF_6$, $SbF_6$ or the like.

[see, for example, Macromolecules *10,* 1307 (1977); Journal of Radiation Curing *5,* 2 (1978); Journal of Polymer Science, Polymer Chemistry Edition *17,* 2877 (1979); Ibid. *17,* 1047 (1979); Journal of Polymer Science, Polymer Letters Edition *17,* 759 (1979); JP—A— 65219/1980; US 4,069,054; and GB 1,516,511 and 1,518,141.]

However, when the photopolymerization of the epoxy resin is carried out with this photo-setting catalyst, the cured material will be improved in mechanical properties, but on the other hand, if used in the field of electric appliances, the cured material will inevitably deteriorate in electrical insulating properties and will corrode peripheral parts, because the added catalyst functions as an ionic impurity.

An object of this invention is to provide a novel photopolymerizable composition which can overcome the aforesaid problems inherent in a photopolymerizable epoxy resin composition, has excellent photo-setting properties and a less corrosive action, and permits giving satisfactory electrical properties to a prepared cured material.

The invention comprises a photopolymerizable epoxy resin composition comprising an epoxy resin and a sulfonium or a iodonium salt, characterized in that the sulfonium salt is a heteropoly-acid aromatic sulfonium salt represented by the formula:

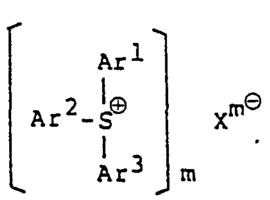

wherein $Ar^1$ to $Ar^3$ may be the same or different from each other, and each represents an aromatic group, or an aromatic group substituted with at least one substituent selected from the group consisting of a

halogen atom, an alkyl group, analkoxy group, an aralkyl group, an aryloxy group, an arylthio group and a nitro group; $X^{m\ominus}$ represents an anion of a heteropoly-acid; and *m* is an integer of 3 to 5; and the iodonium salt is a heteropoly-acid aromatic iodonium salt represented by the formula

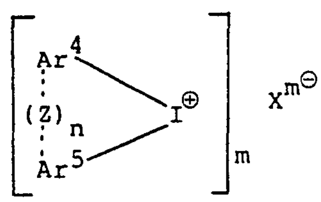

wherein $Ar^4$ and $Ar^5$ may be the same or different from each other, and each represents a substituted or unsubstituted aromatic group or a heterocyclic group each having 6 to 20 carbon atoms; $X^{m\ominus}$ and m have the same meanings as defined above; n is an integer of 0 or 1; and when n is 1, dotted line represents bonding and Z represents an oxygen atom, a sulfur atom,

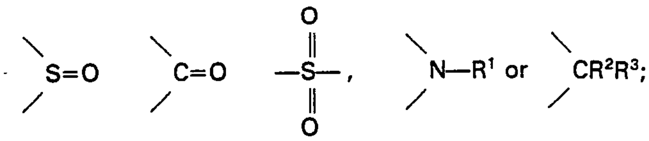

or

where $R^1$ represents a hydrogen atom, an alkyl group having 1 to 10 carbon atoms or an acyl group having 1 to 5 carbon atoms; and $R^2$ and $R^3$ may be the same or different from each other, and each represents a hydrogen atom, an alkyl group having 1 to 4 carbon atoms or an alkenyl group having 2 to 4 carbon atoms; and the amount of the heteropoly-acid aromatic sulfonium salt or the heteropoly-acid aromatic iodonium salt is within the range of 0.001 to 10 parts by weight based on the 100 parts by weight of the epoxy resin; and the heteropoly-acid aromatic iodonium salt is used together with a sensitizer or a quinone.

Examples of the epoxy resins to be used in this invention include a bisphenol A type epoxy resin; a bispohenol F type epoxy resin; a phenol-novolac type epoxy resin; an alicyclic epoxy resin; a heterocyclic ring-containing epoxy resin such as triglycidyl isocyanurate, hydantoin epoxy; a hydrogenated bisphenol A type epoxy resin; an aliphatic epoxy resin such as propylene glycoldiglycidyl ether, pentaerythritol-polyglycidyl ether; a glycidyl ester type epoxy resin obtained by the reaction of an aromatic, aliphatic or alicyclic carboxylic acid with epichlorohydrin; a spiro ring-containing epoxy resin; a glycidyl ether type epoxy resin which is a reaction product of an o-allyl-phenol-novolac compound and epichlorohydrin; a glycidyl ether type epoxy resin which is a reaction product of a diallyl bisphenol compound, having an allyl group at the o-position of each of the hydroxyl groups in bisphenol A, and epichlorohydrin.

Examples of the anions $X^{m\ominus}$ of the heteropoly-acid include a phosphotungstate, a phosphomolybdate, a tunstogermanate, a silicotungstate, a silicomolybdate.

Concrete examples of the heteropoly-acid aromatic sulfonium salt to be used in this invention include triphenylsulfonium phosphomolybdate, triphenylsulfonium phosphotungstate, triphenylsulfonium silicotungstate, tri(methoxyphenyl)sulfonium phosphotungstate, tri(methoxyphenyl)sulfonium silicomolybdate, tri(tert-butylphenyl)sulfonium phosphotungstate, tritolylsulfonium phosphotungstate, tri(2-naphthyl)sulfonium phosphotungstate. Preferably, a phosphotungstate such as triphenylsulfonium phosphotungstate is employed.

In the formula, examples of the aromatic group or the heterocyclic group represented by $Ar^4$ or $Ar^5$ include a phenyl group, a thienyl group, a furanyl group, a pyrazolyl group. These aromatic groups may have one or more condensated benzene ring such as a condensated carbon-hydrogen ring, e.g. naphthyl; a sulfur containing condensated heterocyclic ring, e.g. benzothienyl or dibenzothienyl; and an oxygen-containing condensated heterocyclic ring, e.g. benzofuranyl or dibenzofuranyl.

These aromatic groups may optionally be substituted by one or more substituents as described below. Such a substituent include a halogen atom, a nitro group, a hydroxy group, a carboxyl group, an anilino group or N-alkylanilino group, an ester group (e.g. an alkoxycarbonyl such as methoxycarbonyl or ethoxycarbonyl, a phenoxycarbonyl), a sulfo ester group (e.g. an alkoxysulfonyl such as methoxysulfonyl or ethoxysulfonyl, a phenoxysulfonyl), an amido group (e.g. an acetamide, a butylamide, an ethylsulfonamide), a carbamyl group (e.g. a carbamyl, an N-alkylcarbamyl, an N-phenylcarbamyl), a sulfamyl group (e.g. a sulfamyl, an N-alkylsulfamyl, an N,N-dialkylsulfamyl, an N-phenylsulfamyl), an alkoxy group (e.g. a methoxy, an ethoxy, a butoxy), an aryl group (e.g. a phenyl), an alkyl group (e.g. a methyl, an ethyl, a butyl), an aryloxy group (e.g. a phenoxy), an alkylsulfonyl group (e.g. a methylsulfonyl, an ethylsulfonyl), an arylsulfonyl group (e.g. a phenylsuylfonyl), a perfluoroalkyl group (e.g. a trifluoromethyl, a perfluoroethyl) and a perfluoroalkylsulfonyl group (e.g. a trifluoromethylsulfonyl, a perfluorobutylsulfonyl).

In the formula, $Ar^4$ and $Ar^5$ may be bonded by an oxygen atom, a sulfur atom,

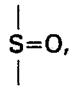, 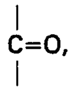, 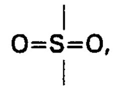, 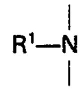

wherein $R^1$ represents a hydrogen atom, a lower alkyl group having 1 to 10 carbon atoms, an acyl group such as an acetyl or a benzoyl), or

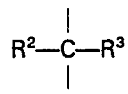

(wherein $R^2$ and $R^3$ may be the same or different and each represents a hydrogen atom, an alkyl group having 1 to 4 carbon atoms, or an alkenyl group having 2 to 4 carbon atoms).

Concrete examples of the heteropoly-acid aromatic iodonium salt to be used in this invention include diphenyliodonium phosphomolybdate, diphenyliodonium phosphotungstate, di(4-methylphenyl)iodonium phosphosilicotungstate, di(4-heptylphenyl)iodonium tungstogermanate, di(5-nitrophenyl)iodonium phosphotungstate, di(4-chlorophenyl)iodonium silicomolybdate, dinaphthyliodonium phosphotungstate, di(4-trifluoromethylphenyl)iodonium phosphotungstate, di(2-benzothienyl)iodonium phosphotungstate, di(2-naphthyl)sulfonium phosphotungstate.

Among them, a diaryliodonium phosphotungstate such as diphenyliodonium phosphotungstate is preferably employed.

These heteropoly-acid aromatic iodonium salt may be prepared by applying the method as disclosed in "Macromolecules *10,* 1307 (1977)".

A mixing amount of the heteropoly-acid aromatic sulfonium salt or the heteropoly-acid aromatic iodonium salt is within 0.001 to 10 parts by weight, preferably within 0.1 to 5 parts by weight based on 100 parts by weight of the epoxy resin. When the amount of the heteropoly-acid aromatic sulfonium salts or the heteropoly-acid aromatic iodonium salt is less than 0.1 parts by weight, the photopolymerization will not make progress to a satisfactory degree; when it is more than 10 parts by weight, there will be induced inconvenient matters such as heightened corrosive properties, increased costs and deteriorated electrical properties.

If the heteropoly-acid aromatic iodonium salt is used, a sensitizer and/or a quinone is used together therewith.

Concrete examples of the sensitizer include:

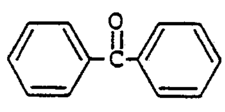, 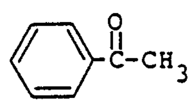, 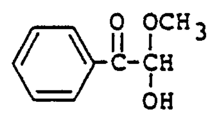,

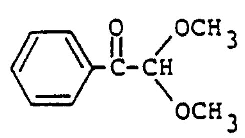, 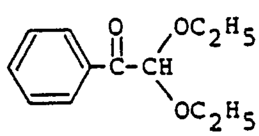, 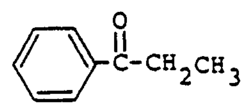,

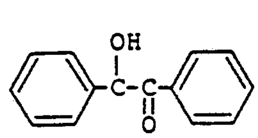, 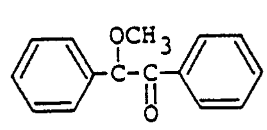, 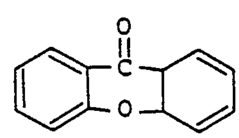,

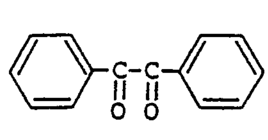, 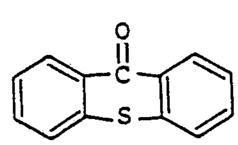, 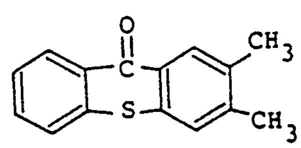,

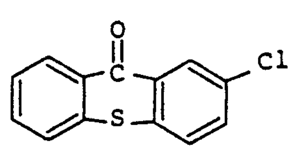,

phenanthrene, naphthalene, 2-nitrofluorene, anthracene, benzoquinone, chrycene. These sensitizer may preferably be mixed in an amount of 0.001 to 20% by weight based on the epoxy resin.

The quinone derivative is a component having a function of regenerating the heteropoly-acid which was lowered in acidity due to the reduction by irradiation of ultraviolet light.

The quinone derivative is a compound having the following formula:

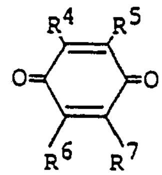

or

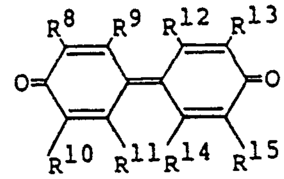

wherein $R^4$, $R^5$, $R^6$, $R^7$, $R^8$, $R^9$, $R^{10}$, $R^{11}$, $R^{12}$, $R^{13}$, $R^{14}$ and $R^{15}$ may be the same or different, and each represents a group selected from the group consisting of a hydrogen atom, a halogen atom, an alkyl group, a cyano group and a nitro group; or a pair selected from the group consisting of $R^4$ and $R^5$, $R^6$ and $R^7$, $R^8$ and $R^9$, $R^{10}$ and $R^{11}$, $R^{12}$ and $R^{13}$, and $R^{14}$ and $R^{15}$ represents an aromatic condensed ring, and concrete example thereof include p-benzoquinone, o-benzoquinone, 1,4-naphthoquinone, 2-methyl-1,4-naphthoquinone, 2,3,5,6-tetrachloro-p-benzoquinone, anthraquinone, phenanthrenequinone, 2-methyl-anthraquinone, benzo-[a]anthraquinone, 1,2-dihydroxyanthraquinone, 4,4'-diphenoquinone, 3,3',5, 5'-tetra-tert-butyl-4,4'-diphenoquinone, 3,3',5,5'-tetramethyl-4,4'-diphenoquinone.

A mixing amount of the quinone derivative is preferably within 0.01 to 10 parts by weight based on 100 parts by weight of the epoxy resin. When the amount of the quinone derivative is less than 0.01 part by weight regeneration of the photopolymerization catalyst will be insufficient; on the contrary, when it exceeds 10 parts by weight, coloring will occur or adhesive property will deteriorate.

When preparing the composition of this invention, a phenol compound of an acid anhydride may optionally be added in addition to the above essential two components.

The photopolymerizable compositions of this invention can be cured by methods such as roomtemperature photocuring, high-temperature photo-curing, after-cure which is effected after the photo-curing. The wavelength of light necessary for the photo-curing will generally be from 180 nm to 600 nm, preferably from 300 nm to 400 nm; the irradiation time will generally be from 0.5 sec to 10 min, preferably from 1 sec to 1 min, depending on the epoxy resin composition and the catalyst to be used; and the temperature in case of high-temperature photocuring will generally be from 20°C to 200°C, prefeably from 60°C to 100°C, depending on the epoxy resin composition and the catalyst to be used. Examples of the light source to be used in this invention may include a high-pressure mercury-vapor lamp, a carbon arc lamp, a xenon lamp, an argon glow discharge tube, metal halide lamp. In case of after-cure which is effected after the photo-curing will generally be carried out at 50°C to 200°C, preferably at 100°C to 180°C, and effected for 1 to 10 hrs, preferably for 2 to 5 hrs, depending on the epoxy resin composition and the catalyst to be used.

The resulting cured material has extremely excellent electrical properties.

As is definite from the foregoing, the composition of this invention can exhibit (1) the photopolymerization being promptly advanced, (2) the cured product being great in hardness, (3) the corrosive action being weak, and (4) the electrical properties being excellent. Therefore, it is fair to say that an industrial utility of the composition of this invention is highly great.

A photopolymerizable composition of this invention will be described in detail as examples.

## Example 1—6

As epoxy resins, there were used Epikote® 828 (trade name, available from Shell Kagaku K.K., Japan; bisphenol A type epoxy resin; epoxy equivalent: 190 to 210), Epikote® 1001 (trade name, available from Shell Kagaku, K.K., Japan; bisphenol A type epoxy resin; epoxy equivalent: 450 to 525; molecular weight: 900) and Epikote® 1004 (trade name, available from Shell Kagaku K.K., Japan; bisphenol A type epoxy resin; epoxy equivalent: 900 to 1000; molecular weight: 1400), and as photopolymerization initiators, there were used triphenylsulfonium phosphotungstate, tri(methylphenyl)sulfonium phosphotungstate and triphenylsulfonium phsophomolybdate.

Each of these materialś was uniformly mixed in compounding proportions (which were represented with "parts by weight") shown in Table 1 below in order to prepare epoxy resin compositions of this invention.

Each of these compositions was applied onto aluminium plates, and was then introduced into an ultraviolet irradiation photo-curing device in which an intensity of the irradiation was adjusted to 80 W/cm, and photo-curing was carried out for a predetermined period of time. The resultant coating films on the plates were tested for pencil hardness and dielectric loss tangent value (tan δ: %) at 180°C. The obtained results are shown in Table 1 all together.

TABLE 1

| | Example | | | | | |
|---|---|---|---|---|---|---|
| | 1 | 2 | 3 | 4 | 5 | 6 |
| Expoxy resin | | | | | | |
| Epikote® 828 | 80 | 80 | 70 | 70 | 50 | 80 |
| Epikote® 1001 | 20 | | 30 | | 20 | 20 |
| Epikote® 1004 | | 20 | | 30 | | |
| Heteropoly-acid aromatic sulfonium salt | | | | | | |
| Triphenylsulfonium phosphotungstate | 4 | | | | | |
| Tri(methylphenyl)sulfonium phosphotungstate | | 4 | | 4 | 4 | |
| Triphenylsulfonium phosphomolybdate | | | 4 | | | |
| Tri(2-naphthyl)sulfonium phosphotungstate | | | | | | 3 |
| Measured value | | | | | | |
| Tan δ (%) | 3.2 | 3.1 | 3.5 | 3.2 | 4.0 | 3.9 |
| Pencil hardness | 2H | 3H | 2H | 3H | 3H | 3H |
| Curing time (sec.) | 30 | 30 | 30 | 45 | 45 | 30 |
| Thickness of coating film (μm) | 20 | 20 | 15 | 15 | 20 | 10 |

Examples 7 to 14

As epoxy resins, there were used Epikote® 828 (trade name, available from Shell Kagaku K.K., Japan; bisphenol A type epoxy resin; epoxy equivalent: 190 to 210), Epikote® 1001 (trade name, available from Shell Kagaku K.K., Japan; bisphenol A type epoxy resin; epoxy equivalent: 450 to 525; molecular weight: 900) and Epikote® 1004 (trade name, available from Shell Kagaku K.K., Japan; bisphenol A type epoxy resin; epoxy equivalent: 900 to 1000; molecular weight: 1400), as heteropoly-acid aromatic iodonium salts, there were used diphenyliodonium phosphotungstate, di(methylphenyl)iodonium phosphotungstate and diphenyliodonium phosphomolybdate, and as the sensitizers, there were used dimethylthioxanthone and benzophenone.

Each of these materials was uniformly mixed in compounding proportions (which are represented with "parts by weight") shown in Table 2 below in order to prepare epoxy resin compositions of this invention.

Each of these compositions was applied onto aluminium plates, and was then introduced into an ultraviolet irradiation photo-curing device in which an intensity of the irradition was adjusted to 80 W/cm, and photo-curing was carried out for a predetermined period of time. The resultant coating films on the plates were tested for pencil hardness and dielectric loss tangent value (tan δ: %) at 180°C. The obtained results are shown in Table 2 all together.

TABLE 2

| | Example | | | | | | | | Comparative example 1 |
|---|---|---|---|---|---|---|---|---|---|
| | 7 | 8 | 9 | 10 | 11 | 12 | 13 | 14 | |
| Epoxy resin | | | | | | | | | |
| Epikote® 828 | 100 | 80 | 80 | 60 | 60 | 50 | 70 | 80 | 100 |
| Epikote® 1001 | — | 20 | — | 40 | 20 | 50 | 20 | 20 | — |
| Epikote® 1004 | — | — | 20 | — | 20 | — | 10 | — | — |
| Heteropoly-acid aromatic iodonium salt | | | | | | | | | |
| Diphenyliodonium phosphomolybdate | 2 | — | — | 2 | — | — | 2 | — | 2 |
| Diphenyliodonium phosphotungstate | — | 2 | — | — | 2 | — | — | — | — |
| Di(methylphenyl)iodonium phosphomolybdate | — | — | 2 | — | — | 2 | — | — | — |
| Di(2-naphthyl)iodonium phosphotungstate | — | — | — | — | — | — | — | 2 | — |
| Sensitizer | | | | | | | | | |
| Dimethylthioxanthone | 1 | 1 | 1 | — | — | 1 | — | 1 | — |
| Benzophenone | — | — | — | 1 | 1 | — | 1 | — | — |
| Measured value | | | | | | | | | |
| Curing time (sec) | 30 | 30 | 50 | 30 | 30 | 60 | 60 | 40 | 60 |
| Tan δ (%) | 2.5 | 3.0 | 2.7 | 2.9 | 2.1 | 3.4 | 3.5 | 2.9 | 3.1 |
| Pencil hardness | 4H | 4H | 5H | 4H | 4H | 4H | 4H | 3H | 3H |
| Thickness of coating film (μm) | 20 | 10 | 15 | 15 | 15 | 10 | 10 | 10 | 10 |

Examples 16 to 20

As epoxy resins, there were used ERL 4211 (trade name, available from Union Carbide Co.; 3',4'-epoxycyclohexylmethyl-3,4-epoxy-cyclohexanecarboxylate), Epikote® 828 (trade name, available from Shell Kagaku K.K., Japan; bisphenol A type epoxy resin; epoxy equivalent: 190 to 210), Epikote® 1001 (trade name, available from Shell Kagaku K.K., Japan; bisphenol A type epoxy resin; epoxy equivalent: 450 to 525; molecular weight: 900), Epikote® 1004 (trade name, available from Shell Kagaku K.K., Japan; bisphenol A type epoxy resin; epoxy equivalent: 900 to 1000; molecular weight: 1400), ERL 4206 (trade name, available from Union Carbide Co.; vinylcyclohexenedioxide) and CY 175 (trade name, available from Chiba Geigy A.G.; alicyclic epoxide), as heteropoly-acid aromatic iodonium salts, there were used diphenyliodonium phosphotungstate, di(methylphenyl)iodonium phosphomolybdate and diphenyliodonium phosphomolybdate, and as quinone derivatives, there were used p-benzoquinone and 1,4-naphthoquinone.

Each of these materials was uniformly mixed in compounding proportions (which were represented with "parts by weight") shown in Table 3 below in order to prepare epoxy resin compositions of this invention.

Each of these compositions was applied onto aluminium plates, and was then introduced into an ultraviolet irradiation photo-curing device in which an intensity of the irradiation was adjusted to 80 W/cm, and photo-curing was carried out for a predetermined period of time.

The resultant coating films on the plates were tested for pencil hardness and dielectric loss tangent value (tan δ: %) at 180°C. The obtained results are shown in Table 3 all together.

TABLE 3

| | Example | | | | | | Comparative example | |
|---|---|---|---|---|---|---|---|---|
| | 15 | 16 | 17 | 18 | 19 | 20 | 2 | 3 |
| Epoxy resin | | | | | | | | |
| Epikote® 828 | — | — | 30 | 20 | 50 | — | — | — |
| Epikote® 1001 | — | — | 20 | — | 20 | 30 | — | — |
| Epikote® 1004 | — | — | — | 20 | — | — | — | — |
| ERL 4221 | 50 | 50 | 50 | 50 | 30 | 50 | 50 | 50 |
| ERL 4206 | 50 | — | — | — | — | 20 | 50 | — |
| CY 175 | — | 50 | — | 10 | — | — | — | 50 |
| Heteropoly-acid aromatic iodonium salt | | | | | | | | |
| Diphenyliodonium phosphomolybdate | — | — | 5 | — | — | — | — | — |
| Diphenyliodonium phosphotungstate | 4 | — | — | 4 | 5 | 5 | 4 | — |
| Di(methylphenyl)iodonium phosphomolybdate | — | 4 | — | — | — | — | — | 4 |
| Quinone derivative | | | | | | | | |
| p-Benzoquinone | 2 | 2 | — | 1 | 1 | 2 | — | — |
| 1,4-Naphthoquinone | — | — | 2 | — | — | — | — | — |
| Measured value | | | | | | | | |
| Tan δ (%) at 180°C | 3.6 | 5.2 | 4.5 | 2.9 | 3.0 | 3.5 | 3.3 | 5.0 |
| Pencil hardness | 5H | H | 2H | 3H | 3H | 3H | 3H | H |
| Curing time (sec.) | 5 | 2 | 5 | 3 | 5 | 5 | 25 | 15 |
| Thickness of coating film (μm) | 20 | 20 | 10 | 20 | 10 | 20 | 20 | 20 |

Example 21

Corrosivity to iron of the epoxy resin compositions of this invention was measured with the Coulostatt method.

An epoxy resin (Celloxide 2021; trade name, available from Daisel K.K., alicyclic epoxy resin) which was photocured (80 W/cm, at a distance of 15 cm for 1 minute) with a catalyst (tri(methoxyphenyl)sulfonium silicotungstate: 1 phr) was crushed into powder having particle size between 0.149 mm :100 meshes) to 0.048 mm (300 meshes). After 50 g of the thus prepared powders were placed in a 500 ml of distilled water and refluxed for an hour, the mixture was filtrated to obtian an aqueous filtrate. An iron plate which was covered with Capton tape (trade name; available from Teraoka Seisakusho Co.) leaving a not covered area of 2 cm × 1, was inserted into the filtrated aqueous solution to measure the corrosive speed.

On the other hand, the same procedures were repeated except that the catalyst was replaced with UVE 1014 (aromatic sulfonium hexafluoroantimonate, available from GE) to prepare Comparative sample 4.

As the results, in the case of epoxy resin composition of this invention, an initial corrosive speed was 9 mg/day/(dm)$^2$ whereas the Comparative sample 4 being 100 mg/day/(dm)$^2$. Therefore, it is confirmed that

the catalyst system of this invention is smaller in corrosive speed than that of the Comparative sample.

**Claims**

1. A photopolymerizable epoxy resin composition comprising an epoxy resin and a sulfonium or a iodonium salt, characterized in that the sulfonium salt is a heteropoly-acid aromatic sulfonium salt represented by the formula:

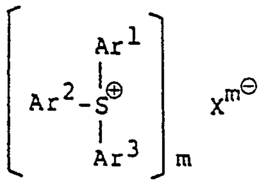

wherein $Ar^1$ to $Ar^3$ may be the same or different from each other, and each represents an aromatic group, or an aromatic group substituted with at least one substituent selected from the group consisting of a halogen atom, an alkyl group, an alkoxy group, an aralkyl group, an aryloxy group, an arylthio group and a nitro group; $X^{m\ominus}$ represents an anion of a heteropoly-acid; and *m* is an integer of 3 to 5; and the iodonium salt is a heterpoly-acid aromatic iodonium salt represented by the formula

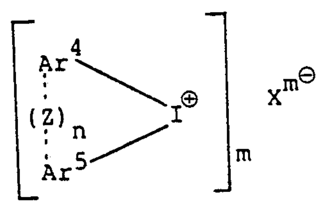

wherein $Ar^4$ and $Ar^5$ may be the same or different from each other, and each represents a substituted or unsubstituted aromatic group or a heterocyclic group each having 6 to 20 carbon atoms; $X^{m\ominus}$ and m have the same meanings as defined above; n is an integer of 0 or 1; and when n is 1, dotted line represents bonding and Z represents an oxygen atom, a sulfur atom,

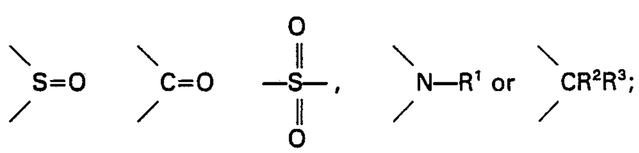

where $R^1$ represents a hydrogen atom, an alkyl group having 1 to 10 carbon atoms or an acyl group having 1 to 5 carbon atoms; and $R^2$ and $R^3$ may be the same or different from each other, and each represents a hydrogen atom, an alkyl group having 1 to 4 carbon atoms or an alkenyl group having 2 to 4 carbon atoms; and the amount of the heteropoly-acid aromatic sulfonium salt or the heteropoly-acid aromatic iodonium salt is within the range of 0.001 to 10 parts by weight based on the 100 parts by weight of the epoxy resin; and the heteropoly-acid aromatic iodonium salt is used together with a sensitizer or a quinone.

2. The photopolymerizable epoxy resin composition according to Claim 1, wherein the epoxy resin is an epoxy resin selected from the group consisting of a bisphenol A type epoxy resin, a bisphenol F type epoxy resin, a phenol-novolac type epoxy resin, an alicyclic epoxy resin, a heterocyclic ring-containing epoxy resin, a hydrogenated bisphenol A type epoxy resin, an aliphatic epoxy resin or glycidyl ester type epoxy resin, a spiro ring-containing epoxy resin and a glycicdyl ether type epoxy resin.

3. The photopolymerizable epoxy resin composition according to Claim 2, wherein the $X^{m\ominus}$ is an anion selected from the group consisting of a phosphotungstate, a phosphomolybdate, a tungstogermanate, a silicotungstate and a silicomolybdate.

4. The photopolymerizable epoxy resin composition according to Claim 2, wherein the heteropoly-acid aromatic sulfonium salt is a compound selected from the group consisting of a triphenylsulfonium phosphomolybdate, triphenylsulfonium phosphotungstate, triphenylsulfonium silicotungstate, tri(methoxyphenyl)sulfonoium phosphotungstate, tri(methoxyphenyl)sulfonium silicomolybdate, tri(tert-butylphenyl)-sulfonium phosphotungstate, tritolylsulfonium phosphotungstate and tri(2-naphthyl)sulfonium phosphotungstate.

5. The photopolymerizable epoxy resin composition according to Claim 1, wherein the $X^{m\ominus}$ is an anion selected from the group consisting of a phosphotungstate, a phosphomolybdate, a tungstogermanate, a silicotungstate and a silicomolybdate.

6. The photopolymerizable epoxy resin composition according to Claim 1, wherein the heterpoly-acid aromatic iodonium salt is a compound selected from the group consisting of diphenyliodonium phosphomolybdate, diphenyliodonium phosphotungstate, di(4-methylphenyl)iodonium phosphosilicotungstate, di(4-heptylphenyl)iodonium tungstogermanate, di(5-nitrophenyl)iodonium phosphotungstate, di(4-chlorophenyl)iodonium silicomolybdate, dinaphthyliodonium phosphotungstate, di(4-trifluoromethylphenyl)iodonium phosphotungstate, di(2-benzothienyl)iodonium phosphotungstate and di(2-naphthyl)iodonium phosphotungstate.

7. The photopolymerizable epoxy resin composition according to Claim 1, wherein the amount of the heteropoly-acid aromatic sulfonium salt or the heteropoly-acid aromatic iodonium salt is within the range of 0.1 to 5 parts by weight based on the 100 parts by weight of the epoxy resin.

8. The photopolymerizable epoxy resin composition according to Claim 1, the sensitizer being a compound selected from the group consisting of

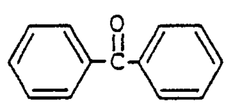 , 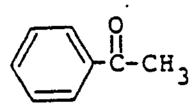 , 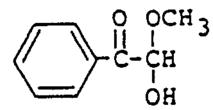 ,

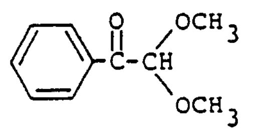 , 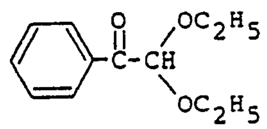 , 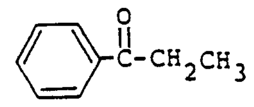 ,

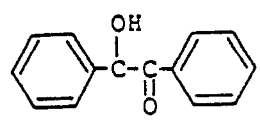 , 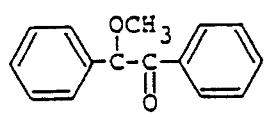 , 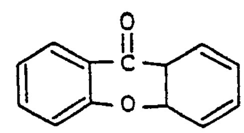 ,

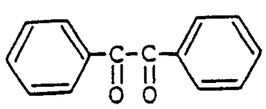 , 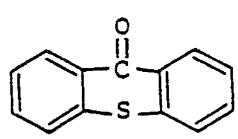 , 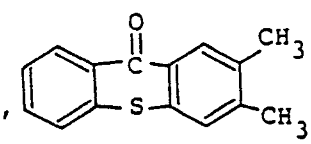 ,

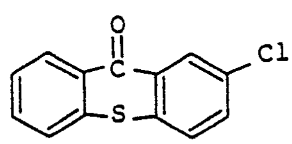 ,

9. The photopolymerizable epoxy resin composition according to Claim 8, the amount of the sensitizer being within the range of 0.001 to 20% by weight based on the epoxy resin.

10. The photopolymerizable epoxy resin composition according to Claim 1, the quinone derivative being a compound represented by the formula:

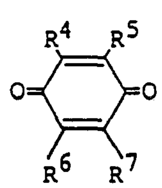 or 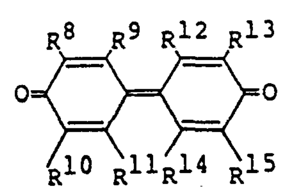

wherein $R^4$, $R^5$, $R^6$, $R^7$, $R^8$, $R^9$, $R^{10}$, $R^{11}$, $R^{12}$, $R^{13}$, $R^{14}$ and $R^{15}$ may be the same or different, and each represents a group selected from the group consisting of a hydrogen atom, a halogen atom, an alkyl group, a cyano group and a nitro group; or a pair selected from the group consisting of $R^4$ and $R^5$, $R^6$ and $R^7$, $R^8$ and $R^9$, $R^{10}$ and $R^{11}$, $R^{12}$ and $R^{13}$, and $R^{14}$ and $R^{15}$ represents an aromatic condensed ring.

11. The photopolymerizable epoxy resin composition according to Claim 1, the quinone derivative being a compound slected from the group consisting of p-benzoquinone, o-benzoquinone, 1,4-naphthoquinone, 2-methyl-1,4-naphthoquinone, 2,3,5,6-tetrachloro-p-benzoquinone, anthraquinone, phenanthrenequinone, 2-methyl-anthraquinone, benzo[a]anthraquinone, 1,2-dihydroxyanthraquinone, 4,4'-diphenoquinone, 3,3',5, 5'-tetra-tert-butyl-4,4'-diphenoquinone, and 3,3',5,5'-tetramethyl-4,4'-diphenoquinone.

12. The photopolymerizable epoxy resin composition according to Claim 1, the amount of the quinone derivative being within the range of 0.01 to 10 parts by weight based on the 100 parts by weight of the epoxy resin.

13. The photopolymerizable epoxy resin composition according to Claim 1, wherein the composition comprises an epoxy resin; a heteropoly-acid aromatic iodonium salt; and a quinone derivative.

## Patentansprüche

1. Fotopolymerisierbare Epoxyharz-Zusammensetzung, umfassend ein Epoxyharz und ein Sulfonium- oder ein Jodoniumsalz, dadurch gekennzeichnet, dass das Sulfoniumsalz ein heteropolysaures, aromatisches Sulfoniumsalz der Formel

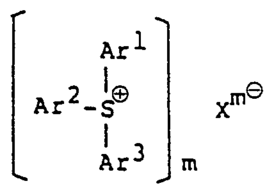

ist, worin $Ar^1$ bis $Ar^3$, die gleich oder verschieden sein können, jeweils eine aromatische Gruppe oder eine aromatische Gruppe, die durch wenigstens einen Substituenten, ausgewählt aus der Gruppe, bestehend aus einem Halogenatom, einer Alkylgruppe, einer Alkoxygruppe, einer Aralkylgruppe, einer Aryloxygruppe, einer Arylthiogruppe und einer Nitrogruppe, substituiert ist, bedeuten; $X^{m\ominus}$ ein Anion einer Heteropolysäure bedeutet und m eine ganze Zahl von 3 bis 5 bedeutet; und das Jodoniumsalz ein heteropolysaures, aromatisches Jodoniumsalz der Formel

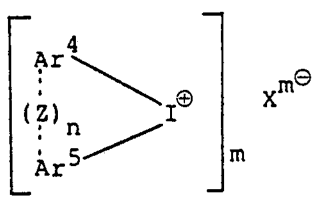

ist, worin $Ar^4$ und $Ar^5$, die gleich oder verschieden sein können, jeweils eine substituierte oder unsubstituierte aromatische Gruppe oder eine heterocyclische Gruppe mit jeweils 6 bis 20 Kohlenstoffatomen bedeuten; $X^{m\ominus}$ und m die vorher angegebenen Bedeutungen haben und n eine ganze Zahl von 0 oder 1 ist; und wenn n 1 ist, die gestrichelte Linie eine Bindung und Z ein Sauerstoffatom, ein Schwefelatom

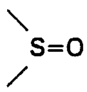 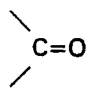 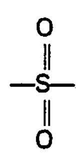, 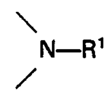 or 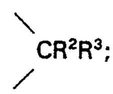;

bedeuten, worin $R^1$ ein Wasserstoffatom, eine Alkylgruppe mit 1 bis 10 Kohlenstoffatomen oder eine Acylgruppe mit 1 bis 5 Kohlenstoffatomen bedeutet; und $R^2$ und $R^3$, die gleich oder verschieden voneinander sein können, jeweils ein Wasserstoffatom, eine Alkylgruppe mit 1 bis 4 Kohlenstoffatomen oder eine Alkenylgruppe mit 2 bis 4 Kohlenstoffatomen bedeuten; und die Menge des heteropolysauren, aromatischen Sulfoniumsalzes oder des heteropolysauren aromatischen Jodoniumsalzes in dem Bereich von 0,001 bis 10 Gew.-Teilen, bezogen auf 100 Gew.-Teile des Epoxyharzes, liegt; und das heteropolysaure, aromatische Jodoniumsalz zusammen mit einem Sensibilisator oder einem Chinon verwendet wird.

2. Fotopolymerisierbare Epoxyharz-Zusammensetzung gemäss Anspruch 1, in welcher das Epoxyharz ein Epoxyharz, ausgewählt aus der Gruppe, bestehend aus einem Epoxyharz vom Bisphenol A-Typ, einem Epoxyharz vom Bisphenol F-Typ, einem Epoxyharz vom Phenol-Novolac-Typ, einem alicyclischen Epoxyharz, einem einen heterocyclischen Ring enthaltenden Epoxyharz, einem Epoxyharz vom hydrierten Bisphenol A-Typ, einem aliphatischen Epoxyharz, einem Epoxyharz vom Glycidylester-Typ, einem einen Spiroring enthaltenden Epoxyharz und einem Epoxyharz vom Glycidylether-Typ ausgewählt ist.

3. Fotopolymerisierbare Epoxyharz-Zusammensetzung gemäss Anspruch 2, bei dem $X^{m\ominus}$ ein Anion,

ausgewählt aus der Gruppe, bestehend aus einem Phosphowolframat, einem Phosphomolybdat, einem Wolframgermanat, einem Silicowolframat und einem Silicomolybdat ist.

4. Fotopolymerisierbare Epoxyharz-Zusammensetzung gemäss Anspruch 2, in welcher das heteropolysaure, aromatische Sulfoniumsalz aus einer Verbindung, ausgewählt aus der Gruppe, bestehend aus Triphenylsulfoniumphosphomolybdat, Triphenylsulfoniumphosphowolframat, Triphenylsulfoniumsilicowolframat, Tri(methoxyphenyl)sulfoniumphosphowolframat, Tri(methoxyphenyl)sulfoniumsilicomolybdat, Tri(tert-butylphenyl)sulfoniumphosphowolframat, Tritolylsulfoniumphosphowolframat und Tri(2-napthyl)sulfoniumphosphowolframat ausgewählt ist.

5. Fotopolymerisierbare Epoxyharz-Zusammensetzung gemäss Anspruch 1, in welcher das $X^{m\ominus}$ ein Anion, ausgewählt aus der Gruppe, bestehend aus einem Phosphowolframat, einem Phosphomolybdat, einem Wolframgermanat, einem Silicowolframat und einem Silicomolybdat, ist.

6. Fotopolymerisierbare Epoxyharz-Zusammensetzung gemäss Anspruch 1, in welcher das heteropolysaure, aromatische Jodoniumsalz eine Verbindung, ausgewählt aus der Gruppe, bestehend aus Diphenyljodoniumphosphomolybdat, Diphenyljodoniumphosphowolframat, Di(4-methylphenyl)jodoniumphosphosilicowolframat, Di(4-heptylphenyl)jodoniumwolframgermanat, Di(5-nitrophenyl)jodoniumphosphowolframat, Di(4-chlorphenyl)jodoniumsilicomolybdat, Dinaphthyljodoniumphosphowolframat, Di(4-trifluormethylphenyl)jodoniumphosphowolframat, Di(2-benzothienyl)jodoniumphosphowolframat und Di(2-naphthyl)jodoniumphosphowolframat ist.

7. Fotopolymerisierbare Epoxyharz-Zusammensetzung gemäss Anspruch 1, in welcher die Menge an heteropolysaurem, aromatischen Sulfoniumsalz oder heteropolysaurem, aromatischen Jodoniumsalz im Bereich von 0,01 bis 5 Gew.-Teilen, bezogen auf 100 Gew.-Teile des Epoxyharzes, liegt.

8. Fotopolymerisierbare Epoxyharz-Zusammensetzung gemäss Anspruch 1, in welcher der Sensibilisator ausgewählt ist aus der Gruppe, bestehend aus

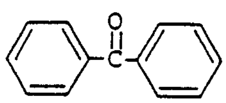 , 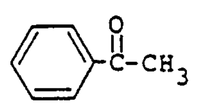 , 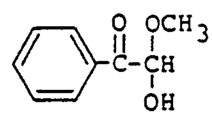 ,

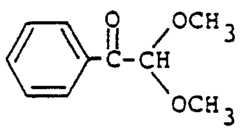 , 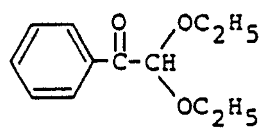 , 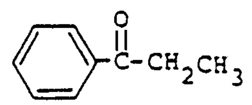 ,

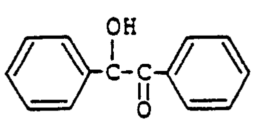 , 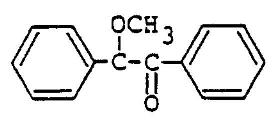 , 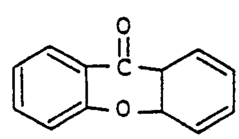 ,

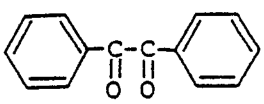 , 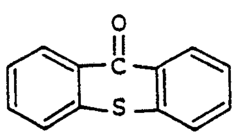 , 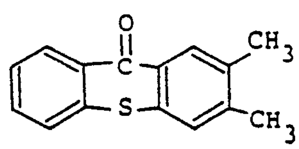 ,

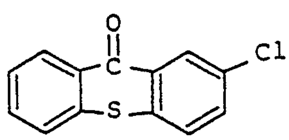 ,

ist.

9. Fotopolymerisierbare Epoxyharz-Zusammensetzung gemäss Anspruch 8, in welcher die Menge des Sensibilisators im Bereich von 0,001 bis 20 Gew.-%, bezogen auf das Epoxyharz, liegt.

10. Fotopolymerisierbare Epoxyharz-Zusammensetzung gemäss Anspruch 1, in welcher das Chinonderivat eine Verbindung der Formeln

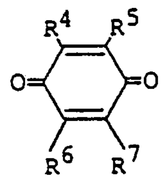

or

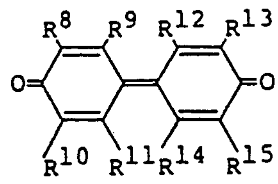

ist, worin $R^4$, $R^5$, $R^6$, $R^7$, $R^8$, $R^9$, $R^{10}$, $R^{11}$, $R^{12}$, $R^{13}$, $R^{14}$ und $R^{15}$ gleich oder verschieden sein können und jeweils eine Gruppe, ausgewählt aus der Gruppe, bestehend aus einem Wasserstoffatom, einem Halogenatom, einer Alkylgruppe, einer Cyanogruppe und einer Nitrogruppe, bedeuten oder ein Paar, ausgewählt aus der Gruppe, bestehend aus $R^4$ und $R^5$, $R^6$ und $R^7$, $R^8$ und $R^9$, $R^{10}$ und $R^{11}$, $R^{12}$ und $R^{13}$, und $R^{14}$ und $R^{15}$ und einen aromatischen kondensierten Ring darstellt.

11. Fotopolymerisierbare Epoxyharz-Zusammensetzung gemäss Anspruch 1, in welcher das Chinonderivat eine Verbindung ist, die aus der Gruppe, bestehend aus p-Benzochinon, o-Benzochinon, 1,4-Naphthochinon, 2-Methyl-1,4-naphthochinon, 2,3,5,6-Tetrachloro-p-benzochinon, Anthrachinon, Phenanthrenchinon, 2-Methyl-anthrachinon, Benzo[a]anthrachinon, 1,2-Dihydroxyanthrachinon, 4,4'-Diphenochinon, 3,3',5,5'-Tetra-tert-butyl-4,4'-diphenochinon und 3,3',5,5'-Tetramethyl-4,4'-diphenochinon, ausgewählt ist.

12. Fotopolymerisierbare Epoxyharz-Zusammensetzung gemäss Anspruch 1, in welcher die Menge des Chinonderivates im Bereich von etwa 0,01 bis 10 Gew.-Teilen, bezogen auf 100 Gew.-Teile des Epoxyharzes, liegt.

13. Fotopolymerisierbare Epoxyharz-Zusammensetzung gemäss Anspruch 1, in welcher die Zusammensetzung ein Epoxyharz, ein heteropolysaures, aromatisches Jodoniumsalz und ein Chinonderivat umfasst.

**Revendications**

1. Composition de résine époxy photopolymérisable, comprenant une résine époxy et un sel de sulfonium ou d'oidonium, caractérisée en ce que le sel de sulfonium est un sel de sulfonium aromatique d'un hétéropolyacide, représenté par la formule:

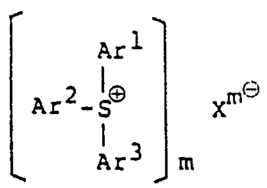

dans laquelle les radicaux $Ar^1$ à $Ar^3$ peuvent être identiques ou différents les uns des autres, et chacun représente un groupe aromatique, ou un groupe aromatique subsitutué par au moins un substituant choisi dans le groupe constitué par un atome d'halogène, un groupe alkyle, un groupe alcoxy, un groupe aralkyle, un groupe aryloxy, un groupe arylthio et un groupe nitro; $X^{m\ominus}$ représente un anion d'un hétéropoly-acide; et *m* est un nombre entier valent de 3 à 5; et le sel d'iodonium est un sel d'iodonium aromatique d'un hétéropoly-acide, représenté par la formule;

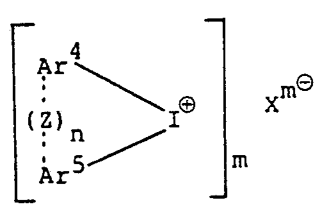

dans laquelle $Ar^4$ et $Ar^5$ peuvent être identiques ou différents l'un de l'autre; et chacun représente un groupe aromatique substitué ou non substitué ou un groupe hétérocyclique, comportant dans chaque cas de 6 à 20 atomes de carbone; $X^{m\ominus}$ et m ont les mêmes significations que celles définis ci-dessus; n est un nombre entier valant 0 ou 1; et, lorsque n vaut 1, le trait en pointillé représente une liaison et Z représente un atome d'oxygène, un atome de soufre,

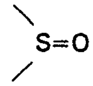 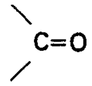 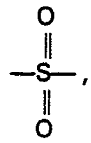, 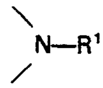 or 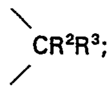;

où R[1] représente un atome d'hydrogène, un groupe alkyle comportant de 1 à 10 atomes de carbone, ou un groupe acyle comportant de 1 à 5 atomes de carbone; et $R^2$ et $R^3$ peuvent être identiques ou différents l'un de l'autre, chacun représentant un atome d'hydrogène, un groupe alkyle comportant de 1 à 4 atomes de carbone, ou un groupe alcényle comportant de 2 à 4 atomes de carbone; et la quantité du sel de sulfonium aromatique d'hétéropoly-acide ou du sel d'iodonium aromatique d'hétéropoly-acide se situe dans le domaine allant de 0,001 à 10 parties en poids pour 100 parties en poids de résine époxy; et le set d'iodonium aromatique d'hétéropoly-acide est utilisé conjointement avec un sensibilisateur ou une quinone.

2. Composition de résine époxy photopolymérisable conforme à la revendication 1, dans laquelle la résine époxy est une résine époxy choisie dans le groupe constitué d'une résine époxy du type bisphénol A, une résine époxy du type bisphénol F, une résine époxy du type phénol-novolaque, une résine époxy alicyclique, une résine époxy à noyau hétérocyclique, une résine époxy du type bisphénol A hydrogéné, une résine époxy aliphatique, une résine époxy du type ester glycidylique, une résine époxy à noyau spiro, et une résine époxy du type éther glycidylique.

3. Composition de résine époxy photopolymérisable conforme à la revendication 2, dans laquelle $X^{m\ominus}$ représente un anion choisi dans le groupe constitué par un phosphotungstate, un phosphomolybdate, un tungstogermanate, un silicotungstate, et un silicomolybdate.

4. Composition de résine époxy photopolymérisable conforme à la revendication 2, dans laquelle le sel de sulfonium aromatique d'hétéropoly-acide est un composé choisi dans le groupe constitué par les phosphomolybdates de triphénylsulfonium les phosphotungstates de triphénylsulfonium, les silicotungstates de triphénylsulfonium, les phosphotungstates de tri(méthoxyphényl)-sulfonium, les silicomolybdates de tri(méthylphényl)-sulfonium, les phosphotungstates de tri(t-butylphényl)-sulfonium, les phosphotungstates de tritolylsulfonium, et les phosphotungstates de tri(2-naphthyl)-sulfonium.

5. Composition de résine époxy photopolymérisable conforme à la revendication 1, dans laquelle $X^{m\ominus}$ représente un anion choisi parmi le groupe constité d'un phosphotungstate, un phosphomolybdate, un tungstogermanate, un silciotungstate et un silicomolybdate.

6. Composition de résine époxy photopolymérisable conforme à la revendication 1, dans laquelle le sel d'iodonium aromatique d'hétéropoly-acide est un composé choisi dans le groupe constitué par les phosphomolybdates de diphényliodonium, les phosphotungstates de diphényliodonium, les phosphosilicotungstates de di(4-méthylphényl)-iodonium, les tungstogermanates de di(4-heptylphenyl)-iodonium, les phosphotungstates de di(5-nitrophényl)-iodonium, les silicomolybdates de di(4-chlorophényl)-iodonium, les phosphotungbstates de dinaphtyliodonium, les phosphotungstates de di(4-trifluorométhylphényl)-iodonium, les phosphotungstates de di(2-benzothiényl)-iodonium, et les phosphotungstates de di(2-naphthyl)-iodonium.

7. Composition de résine époxy photopolymérisable conforme à la revendication 1, dans laquelle la quantité de sel de sulfonium aromatique d'hétéropoly-acide ou de sel d'iodonium aromatique d'hétéropoly-acide se situe dans le domaine allant de 0,1 à 5 parties en poids pour 100 parties en poids de résine époxy.

8. Composition de résine époxy photopolymérisable conforme à la revendication 1, le sensibilisateur étant un composé choisi parmi le groupe consitutué par

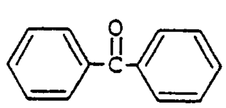, 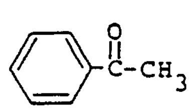, 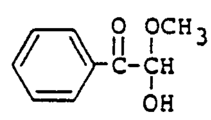,

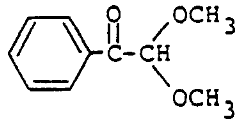, 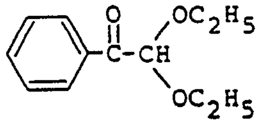, 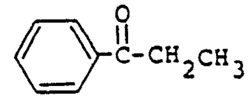,

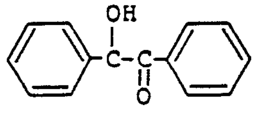, 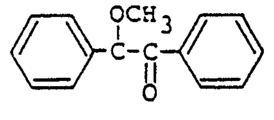, 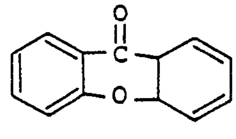,

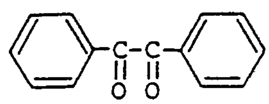 , 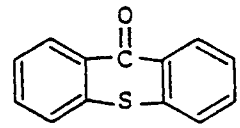 , 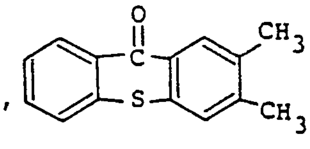 ,

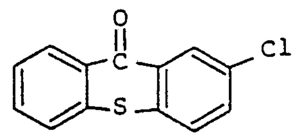 ,

9. Composition de résine époxy photopolymérisable conforme à la revendication 8, la quantité du sensibilisateur étant située dans le domaine allant de 0,001 à 1% en poids par rapport à la résine époxy.

10. Composition de résine époxy photopolymérisable conforme à la revendication 1, le dérivé quinone étant un composé représente par la formule

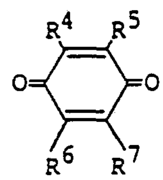 or 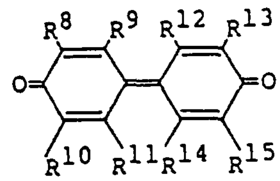

où $R^4$, $R^5$, $R^6$, $R^7$, $R^8$, $R^9$, $R^{10}$, $R^{11}$, $R^{12}$, $R^{13}$, $R^{14}$ et $R^{15}$ peuvent être identiques ou différents, et chacun représente un groupe choisi parmi le groupe constitué par un atome d'hydrogène, un atome d'halogène, un groupe alkyle, un groupe cyano et un groupe nitro; ou bien une paire choisie parmi le groupe constitué par $R^4$ et $R^5$, $R^6$ et $R^7$, $R^8$ et $R^9$, $R^{10}$ et $R^{11}$, $R^{12}$ et $R^{13}$ et $R^{14}$ et $R^{15}$ représente un noyau aromatique condensé.

11. Composition de résine époxy photopolymérisable conforme à la revendication 1, le dérivé quinone étant un composé choisi parmi le groupe constitue par le p-benzoquinone, l'o-benzoquinone, la 1,4-naphthoquinone, la 2-méthyl-1,4-naphthoquinone, la 2,3,5,6-tétrachloro-p-benzoquinone, l'anthraquinone, la phénanthrènequinone, la 2-méthyl-anthraquinone, la benzo(a)anthraquinone, la 1,2-dihydroxyanthraquinone, la 4,4'-diphénoquinone, la 3,3,5,5'-tetra-butyl-4,4'-diphénoquinone et la 3,3',5,5'-tétraméthyl-4,4'-diphénoquinone.

12. Composition de résine époxy photopolymérisable conforme à la revendication 1, la quantité du dérivé quinone étant située dans le domaine allant de 0,01 à 10 parties en poids pour 100 parties en poids de résine époxy.

13. Composition de résine époxy photopolymérisable conforme à la revendication 1, dans laquelle la composition comprend une résine époxy, un sel d'iodonium aromatique d'hétéropoly-acide, et un dérivé quinone.